# EUROPEAN PATENT APPLICATION

(11) **EP 0 901 126 A1**
(43) Date of publication of application: **10.03.1999**
(21) Application number: 97306959.4
(22) Date of filing: 08.09.1997
(51) Int. Cl.: G11B 20/20

(54) **Phase locked loops with common integrator for variable speed tape data storage device**

(71) Applicant: Hewlett-Packard Company, Palo Alto, California 94304 (US)
(72) Inventor: Willcocks, Benjamin Alec, Bristol BS9 1LH (GB)
(74) Representative: Lawman, Matthew John Mitchell

(57) **Abstract**

There is disclosed a method and apparatus for recovering an encoded clock reference signal in a digital data tape storage device in which a plurality of read elements read a plurality of physically recorded data tracks which have been recorded contemporaneously and each using a common clock reference signal encoded into data recorded on each physical data track. Each of a plurality of clock recovery circuits comprises a reference clock generator (404, 409), a phase comparator (405, 410) and a filter element (406, 411). The filter element of each reference clock recovery element applies a proportional gain, which is proportional to a phase difference within the read channel, and an integral gain, which is determined from a plurality of phase difference signals arising from the plurality of other data channel signals read contemporaneously. The integral gain element represents a frequency of the encoded clock signal, determined from the plurality of physically recorded data tracks.

## Description

### Field of the Invention

The present invention relates to a method of reading data stored on a magnetic tape data storage device, and particularly although not exclusively to a method of reference clock signal recovery from a plurality of recorded data channels.

### Background to the Invention

In conventional prior art magnetic tape data storage devices of the type in which an elongate band of magnetic tape is drawn across a substantially static read/write head to produce a physically recorded data track on the tape which extends along a main length of the tape, it is known to incorporate an encoding algorithm into the data as it is recorded onto the tape for the purpose of providing a reference clock signal. The encoding algorithm ensures that the bits of digital data recorded onto the tape are recorded in a manner in which a clock reference frequency signal, or an harmonic of a clock reference frequency signal, is embedded in the recorded data such that the clock signal can be recovered from the encoded data signal when the encoded data signal is subsequently read during playback of the tape.

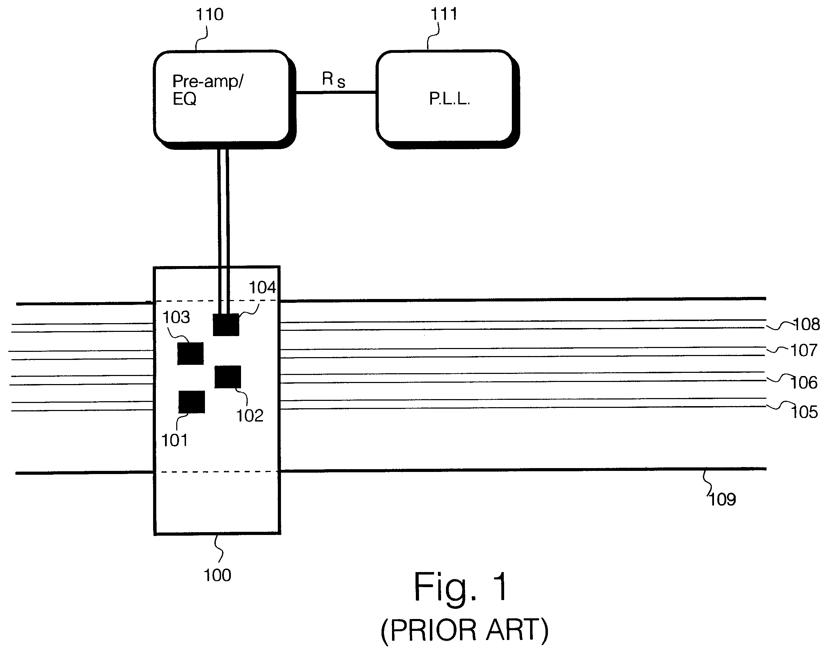

Referring to Figs. 1 to 3 herein, there is illustrated schematically a prior art method of clock signal recovery in a conventional magnetic tape data storage device. The prior art arrangement illustrated in Figs. 1 to 3 herein relates to a generic clock recovery scheme which is applicable to both analogue and digital implementations. A conventional read/write head 100 comprises a plurality of read elements and a plurality of write elements. In the example of Fig. 1, four read elements 101 to 104 are illustrated. Each read element aligns with a physically recorded data track and reads encoded data as a magnetic tape 109 passes the read/write head. Each read element generates a corresponding respective read data channel signal which is input into a pre-amplifier and equalizer 110. The pre-amplifier/equalizer outputs an amplified equalized read data channel signal R_{S} into a phase locked loop 111 for recovery of the clock reference signal from the encoded data.

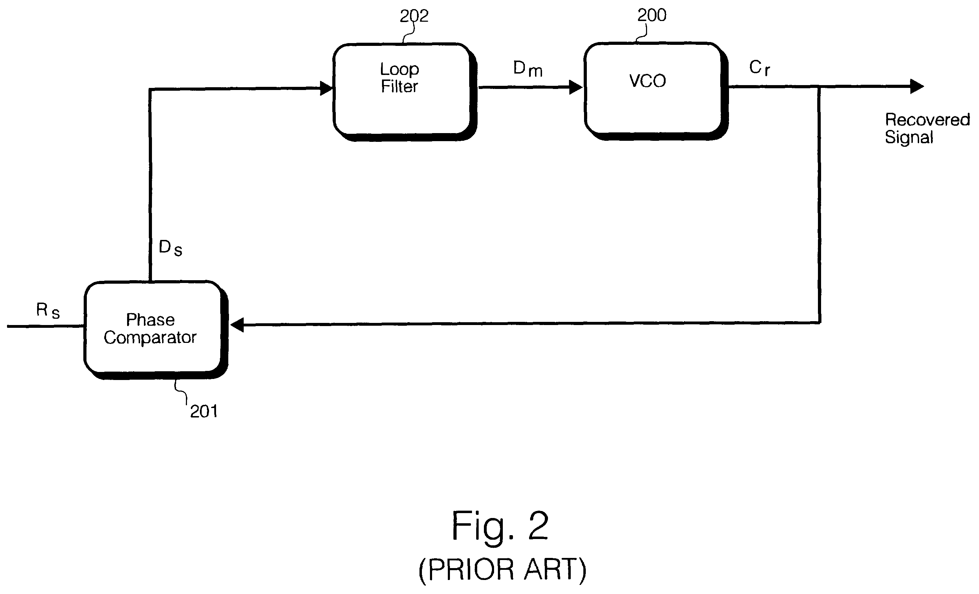

Referring to Fig. 2 herein, there is illustrated internal stages of the phase locked loop 111 for recovering a clock reference signal from a read signal generated by a single read element. The phase locked loop comprises a clock signal generator 200, which in an analogue implementation may comprise a voltage controlled oscillator, or in a digital implementation may comprise a digital divider which divides a fixed frequency digital signal to produce a digital clock reference signal; a phase comparator 201 for comparing a phase of the generated clock reference signal with the incoming pre-amplified equalized read signal, the phase comparator generating a difference signal D_{S}; and a loop filter 202, which filters the difference signal D_{S} to produce a filtered difference signal D_{M}, which is used to control the frequency of the clock signal produced by the clock signal generator 200.

The frequency of the clock reference signal generated by clock reference signal generator 200 is increased or decreased, depending upon the value of the filtered difference signal D_{M}, so that the frequency and phase of generated clock reference signal C_{R} follows the clock reference signal encoded into the read data channel signal R_{S}.

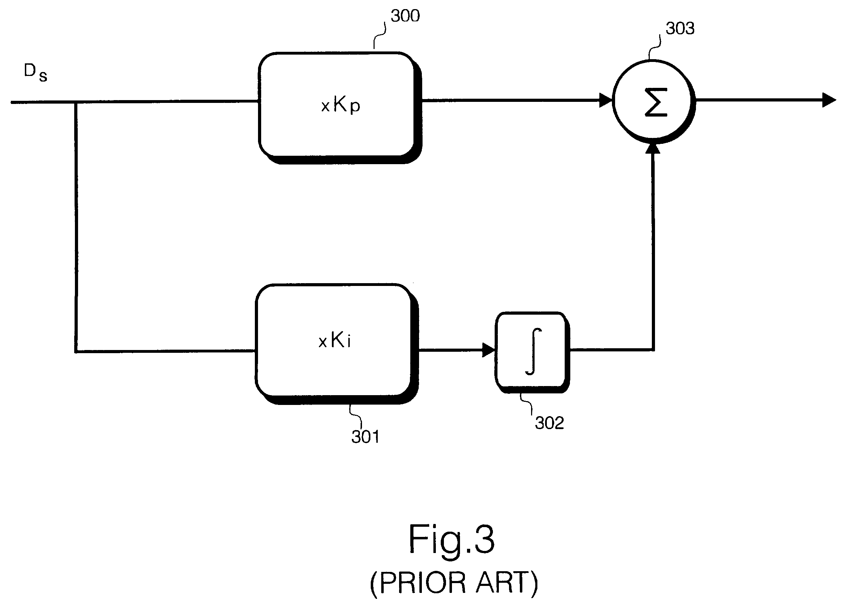

Referring to Fig. 3 herein, there is illustrated in further detail loop filter 202. The loop filter comprises a first amplification stage 300; the first amplification stage arranged in parallel with an integration stage, the integration stage comprising a second gain amplification stage 301 and an integrator 302; and an addition stage 303 for adding resultant outputs of the first amplification stage and the integration stage. First amplification stage 300 applies to the difference signal Dₛ a gain K_{P} which is a constant which determines the proportional gain of the loop filter, whereas second application stage 301 applies an integral gain Kᵢ to the difference signal Dₛ.

Under steady state conditions, where the incoming read channel signal R_{S} is read at a constant rate, the encoded clock reference signal in the read signal is of constant frequency. The active gain contained in the loop filter operates to phase lock the generated clock reference signal C_{R} to the incoming read data channel signal R_{S}, so that the generated clock reference signal C_{R} tracks the encoded clock reference signal embedded in the read data channel signal R_{S} both in phase and frequency.

In the known clock recovery arrangement shown in Figs. 1 to 3, the read data channel Rₛ has associated noise which causes noise in the phase difference signal Dₛ, resulting in some perturbation of the frequency of the generated clock reference signal from an ideal.

It is an ongoing objective of magnetic tape data storage system design to increase the density of recorded data on a physical track of tape. Consequently, as the data density is increased, a signal to noise ratio of the read data channel signal R_{S} decreases and there is a trade-off between increase in recorded data density and worsening of signal to noise ratio in the recovered data channel signal R_{S}. Thus, in the steady state of a played back data channel signal, for an increased data density there will be an increase in jitter on the read data channel signal, making it harder for the generated clock reference signal to be locked onto the phase of the encoded clock reference signal in the read data channel signal. Further, even under normal tape operation, the tape speed may vary from steady state due to variations in tape drive mechanisms, and starting of movement of the tape, and frequency of the encoded clock reference signal will vary and tracking of the phase of the generated clock reference signal to the read data channel signal C_{R} may be lost momentarily as the generated clock reference signal changes frequency value to match changes in frequency in the encoded clock reference signal.

### Summary of the Invention

It is one object of the present invention to provide an improved clock recovery scheme for recovery of an encoded clock reference signal in a read data channel of a magnetic tape data storage device.

Specific methods and embodiments of the present invention are aimed particularly at magnetic tape data storage devices in which a plurality of physical data tracks are each recorded simultaneously and in parallel along the main length of the tape by a write head having a plurality of write elements, each write element recording a corresponding respective data track.

According to a first aspect of the present invention there is provided a method of clock signal recovery of data recorded simultaneously on a plurality of tracks of a magnetic tape data storage device, said method comprising the steps of:
reading said plurality of recorded data tracks simultaneously to obtain a corresponding plurality of data channel signals;
for each data channel signal;
generating a clock reference signal corresponding to said data channel signal; and
generating a difference signal representing a phase difference between said data channel signal and said generated clock reference signal;
   wherein:
said generated clock reference signal is modified in accordance with a signal determined from a plurality of said difference signals of said plurality of data channel signals.

Preferably, said signal determined from a plurality of said difference signals comprises a signal determined from a summation of said plurality of difference signals.

Preferably, said signal determined from a plurality of said difference signals comprises a signal determined by integrating said plurality of difference signals.

In a best mode herein, said tracks are read by a plurality of read elements, wherein each said track is read by a separate read element, and said tracks are read in a direction along a length of said tape.

According to a second aspect of the present invention, there is provided a method of recovering data stored on a magnetic tape data storage medium, said data encoded with a clock reference signal which has been recorded onto a plurality of data tracks of said magnetic tape simultaneously, said method comprising the steps of:
reading said plurality of recorded data tracks simultaneously to obtain a plurality of recovered data channel signals; and
recovering said clock reference signal from said plurality of data channel signals.

Preferably, said step of recovering said clock reference signal comprises:
for each said data channel signal, generating a clock reference signal, said clock reference signal having a frequency determined in part in response to a plurality of difference signals of said plurality of data channels, wherein each said difference signal comprises a signal determined from a phase difference between a said generated clock reference signal and a said data channel signal.

Preferably, said step of recovering said clock reference signal from said plurality of data channel signals comprises:
generating a separate respective clock reference signal for each of said recovered data channel signals;
comparing each said recovered data channel signal with its corresponding respective generated clock reference signal to generate a corresponding respective plurality of difference signals;
filtering each said difference signal to obtain a corresponding respective plurality of filtered difference signals; and
for each said clock reference signal, modifying a frequency of said clock reference signal in response to said gain amplified difference signal, wherein each said gain is determined in part from said plurality of difference signals.

Preferably, each said filter incorporates an integration of said plurality of difference signals.

According to a third aspect of the present invention there is provided a read apparatus for reading a plurality of data tracks recorded onto a magnetic tape data storage medium, said apparatus comprising:
a plurality of read elements, capable of reading a plurality of said data tracks simultaneously, and generating a corresponding plurality of data channel signals;
a plurality of phase determining means, each corresponding to a respective said data track, and arranged to receive a corresponding respective said data channel signal;
wherein said plurality of phase determining means share a common integral gain element.

Deployment of the common integrator for all phase determining elements makes implicit use of the information that all data tracks of the tape have been recorded simultaneously, and therefore have a same frequency as each other. As the clock reference frequency of the recovered data tracks changes, due to change in tape speed, using the specific embodiments herein, the phase determining means sharing a common integral gain element may be able to follow the changes in clock reference frequency more closely than using hitherto known prior art techniques. In particular, an improved lock up performance of each of the phase determining means may be achieved, enabling closer tracking of a phase of a recovered data signal.

By making the phase errors from all channels contribute to an integrator representing information concerning a single clock reference frequency, it may be possible to take advantage of the constraint within the recorded data that the clock reference frequency is the same for each simultaneously recorded channel.

Because the phase error from each of the plurality of channels is input into a single integrator, it may be possible to use a higher loop gain in the phase determining process, whilst minimizing instability and phase jitter. Consequently, a better dynamic performance of the phase determining means may be achieved.

Preferably, said plurality of data tracks are recorded in parallel by a single write head having a plurality of write elements.

Preferably, said plurality of data tracks are read in parallel by a single read head having a plurality of read elements.

According to a fourth aspect of the present invention there is provided a clock signal recovery apparatus for recovering a clock signal from a plurality of data channel signals, said clock signal recovery apparatus comprising:
a plurality of clock recovery means, each comprising:
means for generating a clock reference signal;
means for comparing said clock signal with a said data channel signal, said means generating a difference signal depending on a phase difference between said clock reference signal and said data signal channel;
wherein each said clock recovery means generates a corresponding respective difference signal; and
a said clock reference signal generating means generates a said clock signal in response to a plurality of said difference signals of a plurality of said clock recovery means.

Preferably, said clock signal recovery apparatus further comprising a gain element, said gain element operating to receive a plurality of said difference signals and produce a modified difference control signal in response to said plurality of difference signals; and
said clock reference signal generating means operates to generate a said clock reference signal in response to said control signal.

### Brief Description of the Drawings

For a better understanding of the invention and to show how the same may be carried into effect, there will now be described by way of example only, specific embodiments, methods and processes according to the present invention with reference to the accompanying drawings in which:
Fig. 4 illustrates schematically a layout of a clock recovery apparatus for a multiple channel read apparatus according to a first specific embodiment of the present invention;
Fig. 5 illustrates schematically an arrival time distribution of edge transitions of bits comprising a data channel signal recovered from a physical data track recorded onto a magnetic tape; and
Fig. 6 illustrates schematically an apparatus and method for applying a loop gain in a plurality of clock reference signal recovery circuits according to specific embodiment and method of the present invention.

### Detailed Description of the Best Mode for Carrying Out the Invention

There will now be described by way of example the best mode contemplated by the inventors for carrying out the invention. In the following description numerous specific details are set forth in order to provide a thorough understanding of the present invention. It will be apparent however, to one skilled in the art, that the present invention may be practiced without using these specific details. In other instances, well known methods and structures have not been described in detail so as not to unnecessarily obscure the present invention.

The current best mode according to the present invention described herein relates to a tape data storage device capable of reading a plurality of physical data tracks recorded simultaneously along a main length of an elongate magnetic tape. Each data track may store one or more data channels. In a typical embodiment, a read/write head comprises a plurality of read elements and a plurality of write elements, wherein the plurality of write elements are typically incorporated physically into a same write head, the write elements being spaced apart from each other, each write element operating to record a physical track of data along the tape, the tracks of a plurality of write heads being arranged in parallel to each other. Typically, the read elements are physically incorporated into a single read head, in which each read element aligns with a physically recorded data track of the magnetic tape, such that as the magnetic tape passes the read head, a plurality of data channels are read simultaneously by the plurality of read elements.

However, it will be understood that the exact read/write head layouts may vary widely, and the methods disclosed hereinafter are not restricted to one particular arrangement of read/write head layout.

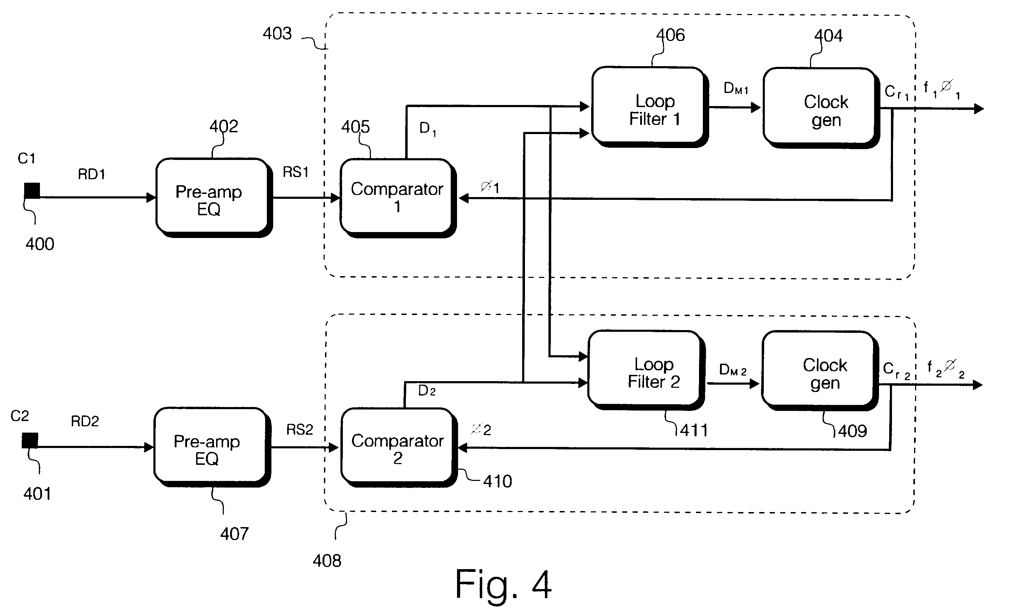

Referring to Fig. 4 herein, there is illustrated schematically a clock recovery circuit for recovering a digitally encoded clock reference signal from digitally recorded data recorded on a physical data track of a magnetic tape. In Fig. 4, there are shown first and second read elements 400, 401, being representative of a plurality of number N of read elements each of which read a corresponding respective physically recorded data track contemporaneously from a single magnetic tape with each other as the magnetic tape passes a read head.

Each read element is provided with a separate corresponding clock signal recovery channel. Referring to the clock signal recovery channel of first read element 400 in Fig. 4 the recovery channel comprises a pre-amplifier/equalizer 402, and a clock recovery element 403.

There will now be described a clock signal recovery channel relating to one such read element. Each other read element has a corresponding similar clock signal recovery channel. First read element 400 generates a recovered data channel signal R_{D1} from a first physically recorded data track on tape, which is input into conventional pre-amplifier and equalizer 402. The pre-amplifier/equalizer amplifies and performs equalization of the recovered data channel signal R_{D1} to produce an amplified, equalized recovered data channel signal R_{S1} in the form of a serial sequence of digital pulses representing the encoded data recorded onto the physical track of magnetic tape. The digital pulses are produced in a form suitable for input to first clock recovery element 403. First clock recovery element 403 comprises first clock generator 404 capable of generating a first digital clock reference signal Cᵣ₁ at a first controllable frequency f₁ and having first phase Ø₁; a first phase comparator 405 operating to compare the first phase Ø₁ of the first generated clock reference signal Cᵣ₁ output from first clock generator 404 with the first data channel signal R_{S1} output from preamplifier 402; the first phase comparator 405 outputting a first difference signal D₁ dependent upon the difference between a phase of the embedded clock reference signal encoded into the first data channel signal R_{S1} and a phase Ø₁ of the first generated clock signal Cᵣ₁ the first difference signal D₁ being input into first loop filter 406, first loop filter 406 providing active gain to first difference signal D₁ and outputting a first modified difference signal D_{M1} which is input into first clock generator 404, the phase Ø1 and frequency f₁ of the first clock reference signal being modified in response to the first modified difference signal D_{M1}.

A second clock signal recovery channel for recovery of a clock reference signal embedded in a second data channel read by second read head 401 comprises second conventional pre-amplifier/equalizer 407 and second clock recovery element 408, the second clock recovery element comprising second clock signal generator 409, second phase comparator 410 and second loop filter 411. The second clock signal generator, second comparator and second loop filter operate similarly as described with reference to the first clock recovery element 403 on a second recorded data channel signal R_{D2} generated by second read element 401. The second clock generator 409 outputs a second clock reference signal Cᵣ₂ of second frequency f₂, and having second phase Ø₂, which is fed back into second phase comparator 410 where it is compared with second data channel signal R_{S2} to produce second difference signal D₂. The second difference signal D₂ is input into second loop filter 411 resulting in a second modified difference signal D_{M2}, which controls the phase and frequency of second generated clock reference signal Cᵣ₂ generated by the second clock generator 409.

Each of the plurality N read elements is provided with a corresponding respective clock signal recovery channel as described for the first and second read elements 400, 401.

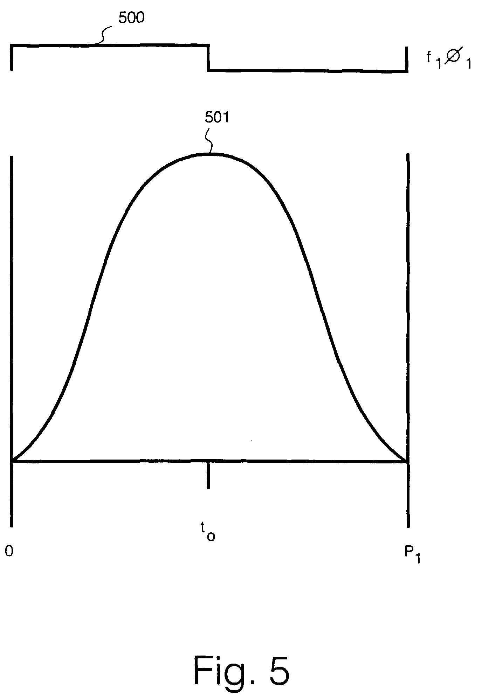

Referring to Fig. 5 herein, there is illustrated schematically a distribution of actual arrival time, of edge transitions of bit signals comprising encoded clock reference signal of first recovered data channel signal R_{S1} within a period P₁ of the embedded encoded clock reference signal 500 as originally recorded. Actual edge transitions of the encoded clock signal in the recovered data channel signal arrive at times before or after their expected time of arrival *t*_{*o*} relative to the period of the encoded clock signal as originally recorded. Whilst most edge transitions of data bits arrive at approximately the correct time with reference to the period of the recorded encoded clock reference signal, since the recorded data density on the physically recorded tracks is as high as possible, there results a degraded signal to noise ratio, which results in jitter of edge transitions, such that a portion of the edge transitions of the bits of the first data channel signal R_{S} arrive both before and after the ideal transition time *t*_{*0*} according to the recorded clock signal period. Edge transitions of arriving bits are distributed around a mean time *t*_{*0*} relative to the encoded clock signal period, even under conditions where the frequency of the recorded encoded clock signal is stable.

However, the data may have been recorded onto tape under conditions of variable tape speed. This may occur because the data may have been recorded by a system which alters the speed of a tape past a write head to compensate for irregular arrival of data from a host device, eg a computer which generates data to be stored. "Bursty" data, such as computer generated data may have been buffered prior to recording, and may have been recorded onto tape at a slower or faster rate, depending on the rate of arrival of data from the host device. In the best mode described herein, recorded tape speed may vary over a speed range typically having a ratio 5:1 as between fastest recorded tape speed and slowest recorded tape speed, or up to a ratio of speeds up to 10:1.

Thus, when reading the physical data tracks, by a read head, the encoded clock frequency as recorded may vary depending upon the tape speed slowing down or accelerating during recording. The generated clock reference signal C_{R1} must track the encoded clock reference signal in frequency as well as in phase over a range of frequencies *f*_{*1*} in the range 1 to 10.

The response time of each clock generator to changes in encoded clock signal frequency is determined by a gain in the loop filter 406. Setting of the gain is a trade off between fast response to changes in frequency and/or phase of the recorded encoded clock reference signal and introduction of errors in data read from the data channel signal R_{S} due to the jitter in arrival of bits of data relative to the encoded clock reference signal, as illustrated schematically in Fig. 5 herein. To obtain fast response times to changes in frequency and/or phase of the encoded clock reference signal, a high gain in the loop filter is advantageous, but increasing the gain increases the rate of error in reading bits of the data channel signal R_{S}.

It is known, from the way in which the plurality of data channels were recorded, that at any time the data channels must have an encoded frequency which is the same in all cases. However, at any particular time the phase of those signals cannot be guaranteed to be the same as between different channels due to variations in head alignment from device to device, tape wander, noise, etc, on each signal channel. In the embodiment shown in Fig. 4 herein, the difference in phase of encoded clock signal as between different data channels is accommodated by each read element being provided with its own corresponding clock recovery channel. However, the information that the frequency of encoded clock signal is the same at any time as between different recorded data channels is utilized by connecting the plurality of clock recovery channels as follows:

In the best mode herein, specific methods and embodiments according to the present invention recognize that by reading a plurality of physical tracks simultaneously which have been recorded simultaneously, at any time the encoded clock reference signal is the same for each data channel recorded on a separate physical data track on the tape. Thus, at any positions along the length of the tape corresponding to the position of write elements at any time, the frequency of the encoded recorded clock reference signal is the same. This information is made use of by incorporating each difference signal D generated by each respective clock recovery channel into the loop filter of each other clock recovery channel, for a plurality of clock recovery channels corresponding to a plurality of read elements which read a corresponding respective plurality of data channels simultaneously.

In Fig. 4 herein, there is shown first difference signal D₁ generated by first clock recovery channel 403 fed into second loop filter 411 of second clock recovery channel 408. Second difference signal D₂ of second clock recovery channel 408 is fed into first loop filter 406 of first clock recovery channel 403. In the general case, a difference signal arising from a first clock recovery channel is fed into a loop filter of every other clock recovery channel which contemporaneously reads a data channel signal of a set of data channel signals all having been recorded simultaneously with a same encoded clock signal.

In each clock recovery channel, of the plurality N clock recovery channels the clock generator is controlled by a feedback signal comprising an amplified phase difference signal resulting from a difference between the generated clock reference signal of that channel and the recovered data channel signal, and a plurality of difference signals generated in each other channel of the plurality N of clock recovery channels.

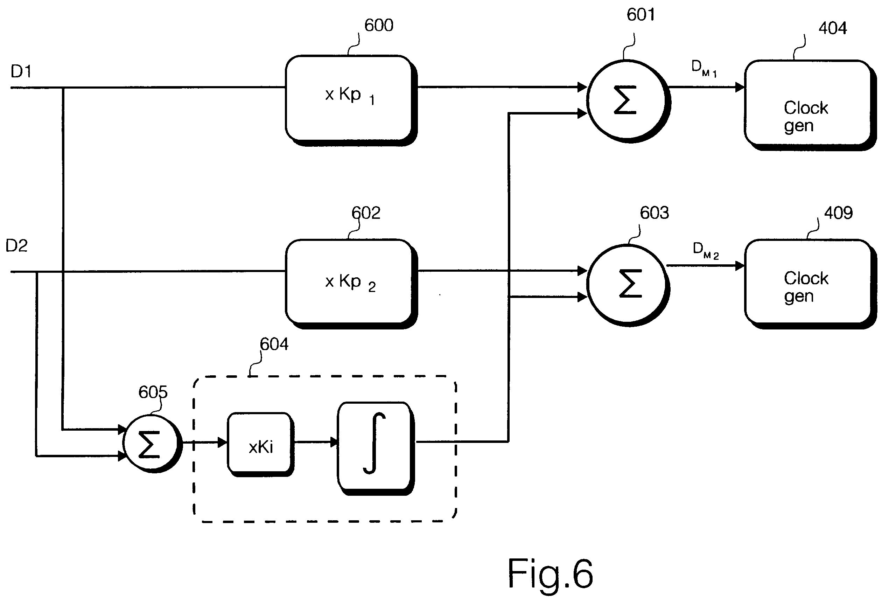

Referring to Fig. 6 herein, there is shown a specific implementation for applying gains in the first and second loop filters of Fig. 4. Although only two clock signal recovery channels are illustrated in Fig. 6, the arrangement and principle of operation applies equally to a plurality of clock signal recovery channels. In each clock signal recovery channel, the loop filter applies a proportional gain K_{P} and an integral gain Kᵢ to its corresponding respective difference signal D generated in a same clock signal recovery channel, as well as applying the integral gain Kᵢ to the difference signal generated by every other clock recovery channel contemporaneously. First loop filter 406 comprises first proportional gain element 600 and first adder 601 and second loop filter 411 comprises second proportional gain element 602 and second adder 603. A common integrator element 604 applying an integral gain Kᵢ to a summation of all difference signals generated contemporaneously in the plurality of clock signal recovery channels is shared by the plurality of loop filters. In the general case of N channels the plurality of N difference signals D₁ to D_{N} are combined by difference signal adder 605 prior to inputting into common integrator 604. In the case of two clock recovery channels shown in Fig. 6, an output of first loop filter 406 comprises first difference signal D₁ multiplied by first proportional gain K_{P1} added to a signal comprising first and second difference signals D₁ + D₂ added together to which is applied integral gain Kᵢ. Similarly, an output signal of second loop filter 411 comprises second difference signal D₂ multiplied by second proportional gain K_{P2} added to the signal comprising first and second difference signals D₁ + D₂ modified by integral gain Kᵢ.

Consequently, a plurality of read elements each read a corresponding respective data channel signal from a respective physical recorded data track on magnetic tape, each data channel signal being encoded with an encoded clock reference signal, there being provided for each read element a corresponding respective clock signal recovery channel. In each clock signal recovery channel there is generated a difference signal corresponding to a difference between the encoded clock reference signal in that channel and a generated clock reference signal corresponding to that channel. Each clock recovery channel applies a gain which is proportional to the difference signal generated in that clock recovery channel, and also applies another gain which is an integral depending on a sum of all of the difference signals applied in all of the channels.

Operations on a data channel signal implemented by the plurality of clock recovery elements 403, 408 of a plurality of number N clock recovery channels operate to generate a separate respective clock reference signal for each recovered data channel signal, compare each recovered data channel signal with its corresponding respective generated clock reference signal generated by clock signal generator 404, 409, to generate a corresponding respective plurality of phase difference signals in phase comparators 405, 410 and apply a respective gain to each phase difference signal in loop filter elements 406, 411 to obtain a corresponding respective plurality of gain amplified phase signals, such that for each generated clock reference signal, a frequency and/or phase of the generated clock reference signal is modified in response to the gain amplified phase difference signal output by the loop filters 406, 409, each loop filter producing an output control signal which is determined in part from the plurality of phase difference signals produced by the plurality of comparators, one per each clock recovery signal channel.

In an implementation of the clock signal recovery apparatus according to the best mode of the invention and as shown in Figs. 4 and 6 herein, the common integrator element 604 comprises a digital integrator, which accumulates a value comprising the plurality of difference signals, the value representing the frequency of the recorded encoded clock signal. Each clock generator generates clock signal having a frequency which is determined by the modified difference signal Dm corresponding to that clock signal recovery channel, the modified difference signal being determined from an amplified phase difference signal D determined from the corresponding physical data track, together with an integral signal determined from the data channel signal of each physical data track, the integral signal representing a common recorded encoded clock signal embedded in each of the data channels recorded on each separate physical data track.

The value stored in the integrator represents the frequency of the recorded encoded clock signal. By making a single integrator common to all clock signal recovery channels, it may be possible to achieve superior lock up performance under conditions of step in frequency from a first frequency to a second frequency, whilst retaining an ability to accommodate data channels having arbitrary relative phases of encoded clock signal. The embodiment described herein is particularly suited to a digital implementation, in which a relationship between the value stored in the integrator, and the recovered clock frequency is fixed, and remains unaffected by process or environmental factors and is not subject to tolerances from one channel to another.

## Claims

1. A method of clock signal recovery of data recorded simultaneously on a plurality of tracks of a magnetic tape data storage device, said method comprising the steps of:
reading said plurality of recorded data tracks simultaneously to obtain a corresponding plurality of data channel signals;
for each data channel signal;
generating a clock reference signal corresponding to said data channel signal; and
generating a difference signal representing a phase difference between said data channel signal and said generated clock reference signal;
wherein:
said generated clock reference signal is modified in accordance with a signal determined from a plurality of said difference signals of said plurality of data channel signals.

2. The method as claimed in claim 1, where said signal determined from a plurality of said difference signals comprises a signal determined from a summation of said plurality of difference signals.

3. The method as claimed in claims 1 or 2, wherein a said signal determined from a plurality of said difference signals comprises a signal determined by integrating said plurality of difference signals.

4. The method as claimed in any one of claims 1 to 3, wherein said tracks are read by a plurality of read elements, wherein each said track is read by a separate read element.

5. The method as claimed in any one of claims 1 to 4, wherein said tracks are read in a direction along a length of said tape.

6. A method of recovering data stored on a magnetic tape data storage medium, said data encoded with a clock reference signal which has been recorded onto a plurality of data tracks of said magnetic tape simultaneously, said method comprising the steps of:
reading said plurality of recorded data tracks simultaneously to obtain a plurality of recovered data channel signals; and
recovering said clock reference signal from said plurality of data channel signals.

7. The method as claimed in claim 6, wherein said step of recovering said clock reference signal comprises:
for each said data channel signal, generating a clock reference signal, said clock reference signal having a frequency determined in part in response to a plurality of difference signals of said plurality of data tracks, wherein each said difference signal comprises a signal determined from a phase difference between a said generated clock reference signal and a said data channel signal.

8. The method as claimed in claims 6 or 7, wherein said step of recovering said clock reference signal from said plurality of data channel signals comprises:
generating a separate respective clock reference signal for each of said recovered data channel signals;
comparing each said recovered data channel signal with its corresponding respective generated clock reference signal to generate a corresponding respective plurality of difference signals;
filtering each said difference signal to obtain a corresponding respective plurality of filtered difference signals; and
for each said clock reference signal, modifying a frequency of said clock reference signal in response to said gain amplified difference signal, wherein each said gain is determined in part from said plurality of difference signals.

9. The method as claimed in claim 8, wherein each said gain is determined in part from an integration of said plurality of difference signals.

10. A read apparatus for reading a plurality of data tracks channels recorded onto a magnetic tape data storage medium, said apparatus comprising:
a plurality of read elements, capable of reading a plurality of said data tracks simultaneously, and generating a corresponding plurality of data channel signals;
a plurality of phase determining means, each corresponding to a respective said data channel, and arranged to receive a corresponding respective said data channel signal;
wherein said plurality of phase determining means share a common integral gain element.

11. The apparatus as claimed in claim 10, wherein said plurality of data tracks are recorded in parallel by a single write head having a plurality of write elements.

12. The apparatus as claimed in claim 10, wherein said plurality of data tracks are read in parallel by a single read head having a plurality of read elements.

13. A clock signal recovery apparatus for recovering a clock signal from a plurality of data channel signals, said clock signal recovery apparatus comprising:
a plurality of clock recovery means, each comprising:
means for generating a clock reference signal;
means for comparing said clock signal with a said data channel signal, said means generating a difference signal depending on a phase difference between said clock reference signal and said data signal channel;
wherein each said clock recovery means generates a corresponding respective difference signal; and
a said clock reference signal generating means generates a said clock signal in response to a plurality of said difference signals of a plurality of said clock recovery means.

14. The clock signal recovery apparatus as claimed in claim 13, further comprising a gain element, said gain element operating to receive a plurality of said difference signals and produce a modified difference control signal in response to said plurality of difference signals; and
said clock reference signal generating means operates to generate a said clock reference signal in response to said control signal.
